# EUROPEAN PATENT APPLICATION

(11) **EP 3 395 905 A1**
(43) Date of publication of application: **31.10.2018**
(21) Application number: 16878513.7
(22) Date of filing: 14.12.2016
(51) Int. Cl.: C08L 83/06, C08G 77/14, C08L 83/04, H01L 23/29, H01L 23/31, H01L 33/56

(54) **SILICONE RESIN COMPOSITION AND SEALING MATERIAL FOR SEMICONDUCTOR LIGHT EMITTING ELEMENT**

(30) Priority: 21.12.2015 JP 2015248968
(71) Applicant: Sumitomo Chemical Company, Limited, Tokyo 104-8260 (JP)
(72) Inventor: HOTTA, Shohei, Tsukuba-shi, Ibaraki 300-3294 (JP); TAKASHIMA, Masayuki, Osaka-shi Osaka 554-8558 (JP)
(74) Representative: Winter, Brandl, Fürniss, Hübner, Röss, Kaiser, Polte - Partnerschaft mbB
(86) International application number: PCT/JP2016/087243
(87) International publication number: WO 2017/110622

(57) **Abstract**

Provided is a silicone resin composition useful for production of a cured product of a silicone resin composition having high UV stability.

A silicone resin composition comprising at least one silicone resin, satisfying the following requirements (i) to (iii) :
(i) silicon atoms contained therein essentially consist of at least one kind of silicon atoms selected from the group consisting of A1 silicon atoms and A2 silicon atoms, and A3 silicon atoms, and a ratio of the content of the A3 silicon atoms to the total content of the A1 silicon atoms, the A2 silicon atoms and the A3 silicon atoms is 50 mol% or more and 99 mol% or less;
(ii) side chains bonding to the silicon atoms are alkyl groups having 1 to 3 carbons, alkoxy groups having 1 or 2 carbons or hydroxyl groups, a molar ratio of the alkoxy groups is less than 5 to 100 of the alkyl groups, and a molar ratio of the hydroxyl groups is 10 or more to 100 of the alkyl groups; and
(iii) a metallic catalyst is not substantially contained.

## Description

### TECHNICAL FIELD

The present invention relates to a silicone resin composition and an encapsulating material for a semiconductor light-emitting element. More specifically, the present invention relates to a silicone resin composition, a cured product of a silicone resin composition, and an encapsulating material for a semiconductor light-emitting element comprising a cured product of a silicone resin composition.

### BACKGROUND ART

In recent years, UV (ultraviolet)-LEDs are beginning to appear on the market. For encapsulation of a UV-LED, a quartz glass is generally used. However, since a quartz glass is expensive, there has been a problem that the product price is high, and the market competitiveness lowers. Further, when encapsulating a UV-LED with a quartz glass, there is a space (encapsulation space) between the UV-LED and the quartz glass. Since both the difference in refractive index in the interface between this space and the surface of the UV-LED, and the difference in refractive index in the interface between this space and the surface of the quartz glass are large, the UV light is reflected, and there has been a problem of poor UV light extraction efficiency. In light of this, it has been proposed to use a cured product of a silicone resin composition as an encapsulating material for a UV-LED.

For example, Patent Document 1 describes using a UV transparent polysilsesquioxane glass having an absorption coefficient of 5 cm⁻¹ or less at a wavelength of 230 to 850 nm as an encapsulating material.

### PRIOR ART DOCUMENT

### PATENT DOCUMENTS

Patent Document 1: JP-A-2013-253223

### SUMMARY OF THE INVENTION

### PROBLEMS TO BE SOLVED BY THE INVENTION

However, the cured product of a silicone resin composition is insufficient in UV light transmittance. Also, the cured product of a silicone resin composition is more likely to deteriorate by UV light than a quartz glass, and the UV light transmittance thereof further deteriorates due to deterioration. Therefore, for using a cured product of a silicone resin composition as an encapsulating material for a UV-LED, a cured product of a silicone resin composition capable of transmitting UV light with high transmittance for a long term has been demanded.

In an encapsulating material using a cured product of a silicone resin composition, the unlikelihood of deterioration by the UV light is also referred to as "UV stability". In an encapsulating material in which a cured product of a silicone resin composition is used, the characteristic of being less likely to deteriorate by UV light, and transmitting UV light with high transmittance for a long term is also referred to as "high UV stability".

The present invention was devised in consideration of these circumstances, and it is an object of the present invention to provide a silicone resin composition useful for production of a cured product of a silicone resin composition which shows high UV stability. It is also an object of the present invention to provide a cured product of the silicone resin composition. It is also an object of the present invention to provide an encapsulating material for a semiconductor light-emitting element, comprising a cured product of the silicone resin composition.

### MEANS FOR SOLVING THE PROBLEMS

The present invention provides the following [1] to [5].

[1] A silicone resin composition comprising at least one silicone resin, satisfying the following requirements (i) to (iii) .
   (i) silicon atoms contained therein essentially consist of at least one kind of silicon atoms selected from the group consisting of A1 silicon atoms and A2 silicon atoms, and A3 silicon atoms, and a ratio of the content of the A3 silicon atoms to the total content of the A1 silicon atoms, the A2 silicon atoms and the A3 silicon atoms is 50 mol% or more and 99 mol% or less;
   (ii) side chains bonding to the silicon atoms are alkyl groups having 1 to 3 carbons, alkoxy groups having 1 or 2 carbons or hydroxyl groups, a molar ratio of the alkoxy groups is less than 5 to 100 of the alkyl groups, and a molar ratio of the hydroxyl groups is 10 or more to 100 of the alkyl groups; and
   (iii) a metallic catalyst is not substantially contained.
      A1 silicon atom denotes a silicon atom in the structural unit represented by the following formula (A1) bonding to one oxygen atom which bonds to a silicon atom in other structural unit, one R¹ and two R²s, or a silicon atom in the structural unit represented by the following formula (A1') bonding to one bonding hand which bonds to an oxygen atom that bonds to a silicon atom in other structural unit, one R¹ and two R²s.
      A2 silicon atom denotes a silicon atom in the structural unit represented by the following formula (A2) bonding to one oxygen atom which bonds to a silicon atom in other structural unit, one bonding hand which bonds to an oxygen atom that bonds to a silicon atom in other structural unit, one R¹ and one R².
      A3 silicon atom denotes a silicon atom in the structural unit represented by the following formula (A3) bonding to two oxygen atoms each of which bonds to a silicon atom in other structural unit, one bonding hand which bonds to an oxygen atom that bonds to a silicon atom in other structural unit, and one R¹.
      R¹ represents an alkyl group having 1 to 3 carbons, and R² represents an alkoxy group having 1 or 2 carbons or a hydroxyl group. 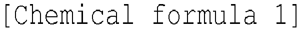 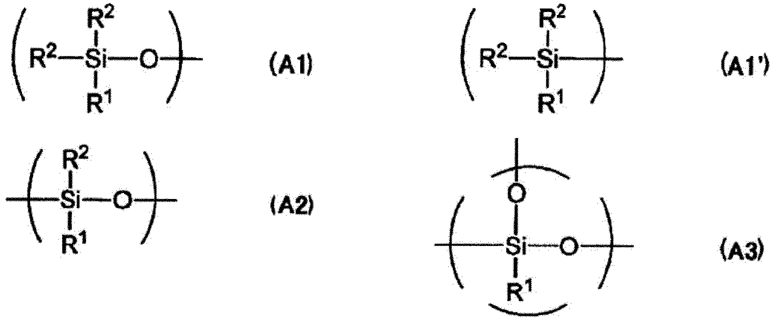
[2] The silicone resin composition according to [1], comprising the following first silicone resin as the silicone resin.
   First silicone resin:
   A silicone resin, wherein silicon atoms contained therein essentially consist of at least one kind of silicon atoms selected from the group consisting of the A1 silicon atoms and the A2 silicon atoms, and the A3 silicon atoms, a ratio of the content of the A3 silicon atoms to the total content of the A1 silicon atoms, the A2 silicon atoms and the A3 silicon atoms is 60 mol% or more and 90 mol% or less, and the silicone resin has a weight-average molecular weight of 1500 or more and 8000 or less.
[3] The silicone resin composition according to [1] or [2], comprising the following second silicone resin as the silicone resin.
   Second silicone resin:
   A silicone resin having a rate of reduction of mass of less than 5%, as measured by raising the temperature of the silicone resin from a room temperature to 200°C at a temperature ramp-up rate of 5°C/min. and then retaining the silicone rasin for 5 hours in air at 200°C.
[4] A cured product of the silicone resin composition according to any one of [1] to [3].
[5] An encapsulating material for a semiconductor light-emitting element, comprising a cured product of the silicone resin composition according to any one of [1] to [3] .

### EFFECT OF THE INVENTION

According to the present invention, it is possible to provide a silicone resin composition useful for production of a cured product of a silicone resin composition which shows high UV stability. Also, according to the present invention, it is possible to provide a cured product of the silicone resin composition. Also, according to the present invention, it is possible to provide an encapsulating material for a semiconductor light-emitting element, comprising a cured product of the silicone resin composition.

### MODE FOR CARRYING OUT THE INVENTION

### [Silicone resin composition]

Hereinafter, a silicone resin composition which is one embodiment of the present invention is described.

A silicone resin composition of the present embodiment is a silicone resin composition comprising at least one silicone resin, satisfying the following requirements (i) to (iii):

The requirement of (i) is named "requirement (i)", the requirement of (ii) is named "requirement (ii)", and the requirement of (iii) is named "requirement (iii)". Hereinafter, each requirement will be described sequentially.

### (Requirement (i))

As described above, A1 silicon atom is a silicon atom in the structural unit represented by the formula (A1), or a silicon atom in the structural unit represented by the formula (A1').

A2 silicon atom is a silicon atom in the structural unit represented by the formula (A2).

A3 silicon atom is a silicon atom in the structural unit represented by the formula (A3).

R¹ represents an alkyl group having 1 to 3 carbons, and R² represents an alkoxy group having 1 or 2 carbons or a hydroxyl group.

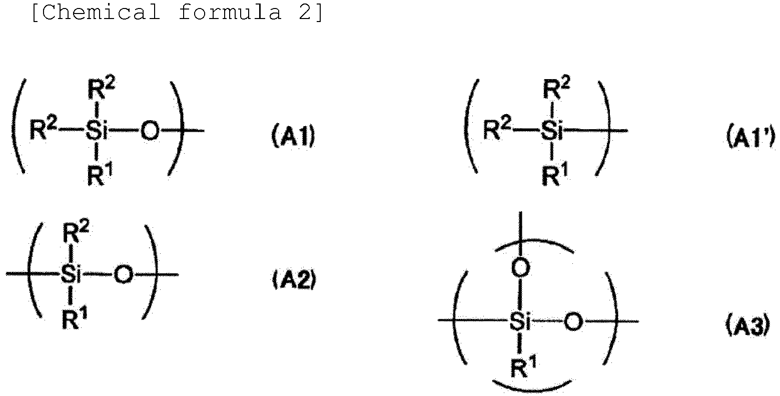

R¹ in the structural unit represented by the formula (A1), R¹ in the structural unit represented by the formula (A1'), R¹ in the structural unit represented by the formula (A2), and R¹ in the structural unit represented by the formula (A3) may be identical or different from each other.

R² in the structural unit represented by the formula (A1), R² in the structural unit represented by the formula (A1'), and R² in the structural unit represented by the formula (A2) may be identical or different from each other.

Two R²s in the structural unit represented by the formula (A1) may be identical or different from each other. Two R²s in the structural unit represented by the formula (A1') may be identical or different from each other.

In a silicone resin, the structural unit represented by the formula (A1) and the structural unit represented by the formula (A1') form terminals of an organopolysiloxane chain. The structural unit represented by the formula (A3) forms a branched-chain structure by an organopolysiloxane chain. That is, the structural unit represented by the formula (A3) forms a part of a network structure or a ring structure in the silicone resin.

The silicon atoms contained in the silicone resin composition of the present embodiment essentially consist of at least one kind of silicon atoms selected from the group consisting of A1 silicon atoms and A2 silicon atoms, and A3 silicon atoms.

The expression "essentially consist of at least one kind of silicon atoms selected from the group consisting of A1 silicon atoms and A2 silicon atoms, and A3 silicon atoms" means that 80 mol% or more of silicon atoms contained in the silicone resin composition are either of A1 silicon atoms, A2 silicon atoms and A3 silicon atoms, preferably, 90 mol% or more are either of A1 silicon atoms, A2 silicon atoms and A3 silicon atoms, and more preferably 95 mol% or more are either of A1 silicon atoms, A2 silicon atoms and A3 silicon atoms.

In the silicone resin composition of the present embodiment, the ratio of the content of the A3 silicon atoms to the total content of the A1 silicon atoms, the A2 silicon atoms and the A3 silicon atoms is preferably 60 mol% or more and 90 mol% or less, more preferably 65 mol% or more and 85 mol% or less.

### (Requirement (ii))

As described above, the silicon atoms contained in the silicone resin composition of the present embodiment essentially consist of at least one kind of silicon atoms selected from the group consisting of A1 silicon atoms and A2 silicon atoms, and A3 silicon atoms. And as indicated by the structural units represented by the formula (A1), the structural unit represented by the formula (A1'), the structural unit represented by the formula (A2) and the structural unit represented by the formula (A3), side chains bonding to silicon atoms are alkyl groups having 1 to 3 carbons, alkoxy groups having 1 or 2 carbons, or hydroxyl groups.

In the silicone resin composition of the present embodiment, a molar ratio of the alkoxy groups of side chains is preferably 0.01 or more and less than 5, more preferably 0.1 or more and less than 5 to 100 of the alkyl groups of side chains.

In the case where the molar ratio of the alkoxy groups of side chains is higher than the above range (less than 5 to 100 of the alkyl groups), the cured product of a silicone resin composition of the present embodiment can no longer transmit UV light with high transmittance for a long term when it is used as an encapsulating material for a UV-LED. In the case where the molar ratio of the alkoxy groups of side chains is lower than the above range (less than 5 to 100 of the alkyl groups), the viscosity of the silicone resin composition becomes high, and the handleability decreases.

An alkoxy group and a hydroxyl group that bond to a silicon atom are functional groups that generate a siloxane bond by condensation reaction. An alkoxy group is more likely to absorb UV light than a hydroxyl group. Therefore, a cured product of the silicone resin composition that comprises more alkoxy groups than hydroxyl groups is more likely to react because unreacted alkoxy groups are likely to absorb UV light at the time of irradiation with UV light. As a result, a cured product which shows low UV stability is obtained.

On the other hand, the silicone resin composition of the present embodiment comprises more hydroxyl groups than alkoxy groups. To be more specific, with respect to the molar ratio of side chains that bond to silicons in the silicone resin composition of the present embodiment, the ratio of the alkoxy groups of side chains is less than 5 to 100 of the alkyl groups of side chains, and the ratio of the hydroxyl groups of side chains is 10 or more to 100 of the alkyl groups of side chains. Therefore, even if a cured product of a silicone resin composition of the present embodiment contains unreacted functional groups, most of the unreacted functional groups are hydroxyl groups, so that the silicone resin composition is less likely to absorb UV light at the time of irradiation with UV light, and is less likely to react. As a result, a cured product which shows high UV stability is obtained.

With respect to the molar ratio of side chains that bond to silicon atoms in the silicone resin composition of the present embodiment, the ratio of the hydroxyl groups of side chains is preferably less than 30, more preferably less than 20, to 100 of the alkyl groups of side chains. By setting the molar ratio of the hydroxyl groups of side chains within the above range (less than 30 to 100 of the alkyl groups), it is possible to suppress volume contraction at the time of curing of the silicone resin composition, and to suppress coloring by irradiation with UV light.

When an alkoxy group bonding to a silicon atom generates a siloxane bond by condensation reaction, first, a silicon atom bonding to an alkoxy group, and moisture react with each other to convert the alkoxy group into a hydroxyl group. Then, an oxygen atom in the hydroxyl group bonding to the silicon atom reacts with other silicon atom to generate a siloxane bond. That is, since the hydroxyl group (silanol group) shows higher reactivity between the alkoxy group and the hydroxyl group that bond to a silicon atom, a siloxane bond is more likely to be generated.

Therefore, the silicone resin composition of the present embodiment satisfies the molar ratio of side chains bonding to silicon atoms within the above range, a siloxane bond can be generated and curable even when the later-described requirement (iii) (a metallic catalyst for curing is not substantially contained) is satisfied.

The molar ratio of the alkoxy groups to the alkyl groups that bond to silicon atoms, and the molar ratio of the hydroxyl groups to the alkyl groups in the silicone resin composition of the present embodiment can be appropriately combined as long as the above ranges are satisfied.

The silicone resin contained in the silicone resin composition of the present embodiment can be synthesized by using as a starting material an organic silicon compound corresponding to each of the aforementioned structural units and having a functional group capable of generating a siloxane bond. The "functional group capable of generating a siloxane bond" may be, for example, a halogen atom, a hydroxyl group or an alkoxy group. Examples of the organic silicon compound corresponding to the structural unit represented by the formula (A3) include organotrihalosilane and organotrialkoxysilane.

A silicone resin can be synthesized through reaction by the hydrolysis condensation method using organic silicon compounds which are starting materials in a ratio corresponding to an existence ratio of each structural unit. By appropriately selecting the organic silicon compounds which are starting materials, it is possible to adjust the existence ratio of A3 silicon atoms contained in the silicone resin. The silicone resin thus synthesized is industrially commercially available as a silicone resin or the like.

### (Requirement (iii))

As described above, the silicone resin composition of the present embodiment does not substantially comprise a metallic catalyst.

In general, a catalyst for curing such as an acidic compound (acid catalyst), a basic compound (base catalyst) and a metallic compound (metallic catalyst) can be added to the silicone resin composition. Examples of known metallic catalysts include catalysts comprising typical metals such as aluminum compounds such as aluminum acetylacetonate, and catalysts comprising transition metals which are elements existing between the group 3 elements and the group 11 elements in the periodic table such as platinum, ruthenium, tin, zirconium, zinc and cobalt. Among these, metallic catalysts comprising aluminum, platinum or tin are particularly known.

On the other hand, it is preferable that the silicone resin composition of the present embodiment does not substantially comprise a metallic catalyst, and does not substantially comprise a catalyst for curing. In the silicone resin composition of the present embodiment, the expression "substantially not comprise" a metallic catalyst means that the content of the metallic catalyst in the silicone resin composition is 50 ppm (parts per million) or less. The content of the metallic catalyst in the silicone resin composition is preferably smaller within the range of "substantially not contain" (50 ppm (parts per million) or less) . The content of the metallic catalyst in the silicone resin composition of the present embodiment is preferably 10 ppm or less, more preferably 5 ppm or less.

The silicone resin composition may comprise a solvent for facilitating the handling. However, when the silicone resin composition comprises a catalyst for curing, curing of the silicone resin composition is accelerated, so that there is a case that curing of the silicone resin composition completes in the condition that a solvent contained in the silicone resin composition remains, and there is a case that the cured product of the silicone resin composition involves the solvent. In such a case, the solvent degrades by irradiation with UV light, and the transmittance of UV light of the cured product of the silicone resin composition can decrease, so that the UV stability of the cured product of the silicone resin composition can decrease.

On the other hand, when the silicone resin composition of the present embodiment does not comprise a catalyst for curing, it becomes possible to remove a solvent before completion of curing of the silicone resin composition, so that it is possible to suppress decrease of the transmittance of UV light of the cured product of the silicone resin composition.

Also, the silicone resin composition of the present embodiment does not substantially comprise a metallic catalyst. Accordingly, in the cured product of the silicone resin composition, a metal that constitutes a metallic catalyst does not absorb UV light, and as a result the transmittance of UV light of the cured product of the silicone resin composition is less likely to decrease. Therefore, the silicone resin composition of the present embodiment is useful for production of a cured product of a silicone resin composition which shows high UV stability.

Next, configuration of the silicone resin composition of the present embodiment will be described in detail.

### (First silicone resin)

The silicone resin composition of the present embodiment preferably comprises the first silicone resin.

In the first silicone resin, the ratio of the content of the A3 silicon atoms to the total content of the A1 silicon atoms, the A2 silicon atoms and the A3 silicon atoms is preferably 70 mol% or more and 85 mol% or less.

In the silicone resin, the kind and the existence ratio of the functional groups bonding to the silicon atoms can be measured, for example, by using the nuclear magnetic resonance spectrometry (NMR method). The nuclear magnetic resonance spectrometry (NMR method) is described in detail in various documents and the like, and excusive-use measurement apparatus are widely commercially available. Specifically, the kind and the existence ratio of each functional group in the silicone resin can be measured by dissolving the silicone resin constituting the object of measurement into a specific solvent, giving a strong magnetic field and a high-frequency radio wave to the hydrogen atom nucleus or the silicon atom nucleus in the silicone resin, and resonating the nuclear magnetic moment in the atomic nucleus. A method of measuring the hydrogen atom nucleus is referred to as ¹H-NMR, and a method of measuring the silicon atom nucleus is referred to as ²⁹Si-NMR. As the solvent for use in measurement in the nuclear magnetic resonance spectrometry (NMR method), heavy chloroform, heavy dimethyl sulfoxide, heavy methanol, heavy acetone, heavy water or the like may be selected in accordance with the kind of various functional groups in the silicone resin.

The ratio of the content of the A3 silicon atoms can be determined by dividing the area of the signals assigned to the A3 silicon atoms by the total of the area of the signals assigned to the A1 silicon atoms, the area of the signals assigned to the A2 silicon atoms and the area of the signals assigned to the A3 silicon atoms as determined by using ²⁹Si-NMR measurement.

In the structural units contained in the first silicone resin, R¹ is preferably a methyl group.

When R² is an alkoxy group, it is preferably a linear alkoxy group. The number of carbons of the alkoxy group is preferably 1 to 2. Specifically, the alkoxy group is preferably a methoxy group or an ethoxy group.

The first silicone resin preferably has an organopolysiloxane structure represented by the following formula (1). In the formula (1), R¹ and R² have the same meanings as described above. p¹, q¹, a¹ and b¹ represent arbitrary positive numbers.

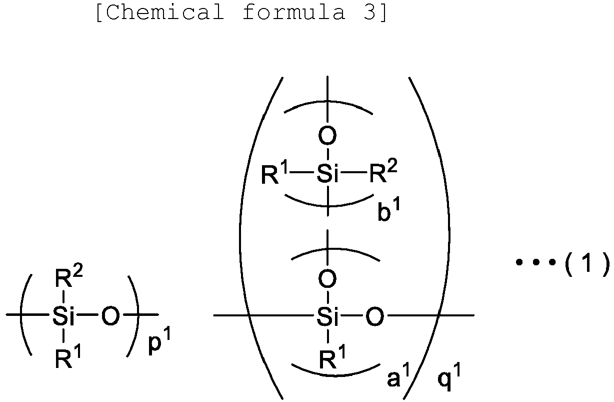

In the organopolysiloxane structure represented by the formula (1), R¹ is an alkyl group having 1 to 3 carbons, and is preferably a methyl group. R² is an alkoxy group having 1 or 2 carbons or a hydroxyl group. When R² is an alkoxy group, a methoxy group or an ethoxy group is preferred as the alkoxy group.

Regarding the existence ratio of the respective structural units in the organopolysiloxane structure represented by the formula (1), the content ratio of the A3 silicon atoms (= y¹/(x¹ + y¹)) to the total content of the number of the A2 silicon atoms: x¹ (= p¹ + b¹ × q¹) and the number of the A3 silicon atoms: y¹ (= a¹ × q¹) is within the range of 0.6 to 0.9. That is, the ratio of the content of the A3 silicon atoms to the total content of the A1 silicon atoms, the A2 silicon atoms and the A3 silicon atoms is 60 mol% or more and 90 mol% or less. The numerical values of p¹, q¹, a¹ and b¹ can be appropriately adjusted to achieve such a range.

Since the first silicone resin has a high existence ratio of the A3 silicon atoms, a silicone-based resin cured product in which the organopolysiloxane chains are configured in a net form can be obtained by curing the first silicone resin. When the existence ratio of the A3 silicon atoms is higher than the aforementioned range (0.6 to 0.9), cracking becomes more likely to occur in the silicone-based resin cured product, whereas when the existence ratio of the A3 silicon atoms is lower than the aforementioned range (0.6 to 0.9), the UV stability of the cured product of a silicone resin composition can be low.

Since the first silicone resin is a silicone resin having an organopolysiloxane structure in which the existence ratio of the A3 silicon atoms in the formula (1) is within the aforementioned range (0.6 to 0.9), the cured product of the silicone resin composition comprising the first silicone resin tends to show high UV stability. In the first silicone resin, the content of A3 silicon atoms (= y¹/(x¹ + y¹)) is preferably within the range of 0.7 to 0.85.

The numbers of A2 silicon atoms and A3 silicon atoms per one molecule of the first silicone resin can be adjusted by controlling the molecular weight of the resin having an organopolysiloxane structure represented by the formula (1) . In the present embodiment, it is preferable that the total of the number of A2 silicon atoms and the number of A3 silicon atoms per one molecule of the first silicone resin is 5 or more.

The weight-average molecular weight (Mw) of the first silicone resin is 1500 or more and 8000 or less. When the weight-average molecular weight of the first silicone resin is too small, the UV stability of the cured product of the silicone resin composition of the present embodiment tends to be low. When the weight-average molecular weight of the first silicone resin is within the above range, a cured product being more excellent in the UV stability can be produced. The weight-average molecular weight of the first silicone resin is more preferably 2000 or more and 5000 or less.

As a weight-average molecular weight (Mw) of a silicone resin, it is possible to use a value determined generally by the gel permeation chromatography (GPC) method. Specifically, after a silicone resin is dissolved into a soluble solvent, the resultant solution is passed together with a mobile-phase solvent in a column in which a filler containing a lot of fine holes (pores) is used, and separation is made in accordance with the size of the molecular weight in the column, and the contents of the molecular weight components thus separated are detected by using a differential refractometer, a UV meter, a viscometer, a light-scattering detector or the like as a detector. A GPC dedicated device is widely marketed, and weight-average molecular weight (Mw) is generally measured by standard polystyrene conversion. Weight average molecular weight (Mw) in this description means a measurement by the standard polystyrene conversion.

In measurement of weight-average molecular weight by the GPC method, the solvent for use in dissolving the silicone resin is preferably the same solvent as the mobile-phase solvent for use in the GPC measurement. Specific examples of the solvent include tetrahydrofuran, chloroform, toluene, xylene, dichloromethane, dichloroethane, methanol, ethanol and isopropyl alcohol. The column for use in the GPC measurement is commercially available, and an appropriate column may be used in accordance with the presumed weight-average molecular weight.

The first silicone resin can be synthesized by using as a starting material an organic silicon compound corresponding to each of the aforementioned structural units constituting the first silicone resin and having a functional group capable of generating a siloxane bond. The "functional group capable of generating a siloxane bond" represents the same meaning as described above. Examples of the organic silicon compound corresponding to the structural unit represented by the formula (A3) include organotrihalosilane and organotrialkoxysilane. The first silicone resin can be synthesized through reaction by the hydrolysis condensation method using such organic silicon compounds which are starting materials in a ratio corresponding to an existence ratio of each structural unit. The silicone resin thus synthesized is industrially commercially available as a silicone resin or the like.

### (Second silicone resin)

The silicone resin composition of the present embodiment preferably comprises the second silicone resin, and more preferably comprises the first silicone resin and the second silicone resin. The second silicone resin is a silicone resin having a rate of reduction of mass of less than 5%, as measured by raising the temperature of the silicone resin from a room temperature to 200°C at a temperature ramp-up rate of 5°C/min. and then retaining the silicone resin for 5 hours in air at 200°C. The temperature raising step from a room temperature to 200°C at a temperature ramp-up rate of 5°C/min. is normally carried out in air.

The second silicone resin has little unreacted functional groups, and is thermally stable. Therefore, in the cured product of the silicone resin composition comprising the second silicone resin, the second silicone resin functions as a filler. Therefore, the second silicone resin contributes to improvement in mechanical strength of the cured product of the silicone resin composition.

Also, the second silicone resin has little unreacted functional groups, and is less likely to degrade even when it is irradiated with UV light. Therefore, by blending the second silicone resin, it is possible to further improve the UV stability of the cured product of the silicone resin composition.

The second silicone resin is not particularly limited as long as it is thermally stable, and specifically, silicone resins having a fine particulate structure that is called silicone rubber powder or silicone resin powder can be used.

Among the silicone resins having a fine particulate structure, globular silicone resin powder composed of a polysilsesquioxane resin in which the siloxane bond has a three-dimensional network structure represented by (RSiO_{3/2}) is preferred. In (RSiO_{3/2}), R is preferably a methyl group.

When the second silicone resin is globular silicone resin powder, a mean particle diameter of the silicone resin powder is preferably 0.1 µm or more and 50 µm or less, more preferably 1 µm or more and 30 µm or less, further preferably 2 µm or more and 20 µm or less.

When the mean particle diameter of the silicone resin powder is within the above range (0.1 µm or more and 50 µm or less), there is a tendency that occurrence of peeling in the interface between the cured product of a silicone resin composition and the substrate, cloudiness of the cured product of a silicone resin composition, and deterioration in light permeability of the cured product of a silicone resin composition can be easily suppressed.

The mean particle diameter of the silicone resin powder can be measured, for example, by a particle size distribution measuring device utilizing "laser diffraction scattering method" as a measurement principle. This technique measures a particle diameter distribution of particles by utilizing that diffracted light and scattering light are emitted in various directions depending on the sizes of particles when the particles are irradiated with a laser beam (monochromatic light), and can determine a mean particle diameter from the distribution state of the diffracted light and the scattering light. Devices that utilize "laser diffraction scattering method" as a measurement principle are commercially available from many manufacturers.

As the second silicone resin, a commercially available product can be used. For example, KMP-710, KMP-590, X-52-854 and X-52-1621 (available from Shin-Etsu Chemical Co., Ltd.), Tospearl 120, Tospearl 130, Tospearl 145, Tospearl 2000B, Tospearl 1110 and Tospearl (available from Momentive Performance Materials Inc.), and MSP-N050, MSP-N080 and MSP-S110 (available from NIKKO RICA CORPORATION) can be used.

When the silicone resin composition of the present embodiment is a silicone resin composition liquid comprising the first silicone resin, the second silicone resin and a solvent for dissolving or dispersing these silicone resins, the total content of the first silicone resin, the second silicone resin, and the solvent contained in the silicone resin composition liquid is preferably 80% by mass or more, more preferably 90% by mass or more.

The ratio of the content of the second silicone resin (fractional resin content) to the total content of the first silicone resin and the second silicone resin is preferably 20% by mass or more and 90% by mass or less, more preferably 40% by mass or more and 80% by mass or less. When the fractional resin content of the second silicone resin is within the above range, there is a tendency that a cured product of a silicone resin composition having excellent cracking resistance and excellent UV stability in good balance can be obtained.

The "cracking resistance" in the present description means the unlikelihood of occurrence of cracking in the cured product of a silicone resin composition. The unlikelihood of occurrence of cracking in the encapsulating material using the cured product of a silicone resin composition is also referred to as "high cracking resistance".

As a cause of occurrence of cracking in the cured product of a silicone resin composition, volume contraction at the time of curing of the silicone resin composition, thermal shock occurring when the cured product is rapidly exposed to the high temperature environment from the low temperature environment, degradation of the cured product by irradiation with UV light and so on are conceivable. When the silicone resin composition of the present embodiment contains the second silicone resin, it is possible to suppress occurrence of any cracking by the aforementioned causes.

### (Solvent)

The silicone resin composition of the present embodiment may comprise a solvent for facilitating the handling.

The solvent is preferably an organic solvent having a boiling point of 100°C or higher at normal pressure. Organic solvents having a boiling point of less than 100°C are easy to evaporate, so that the concentration of the silicone resin composition is likely to change, and the silicone resin composition is likely to be difficult to handle. On the other hand, in silicone resin composition containing an organic solvent having a boiling point of 100°C or higher, such a problem tends to be suppressed.

Specific examples of the organic solvents include ester solvents such as 2-ethoxyethyl acetate (boiling point: 156°C) ; glycol ether solvents such as ethylene glycol monomethyl ether, ethylene glycol monoethyl ether, ethylene glycol monoisopropyl ether, ethylene glycol monobutyl ether, ethylene glycol monohexyl ether, ethylene glycol monoethylhexyl ether, ethylene glycol monophenyl ether, ethylene glycol monobenzyl ether, diethylene glycol monomethyl ether, diethylene glycol monoethyl ether, diethylene glycol monoisopropyl ether, diethylene glycol monobutyl ether, diethylene glycol monohexyl ether, diethylene glycol monoethylhexyl ether, diethylene glycol monophenyl ether, diethylene glycol monobenzyl ether, propylene glycol monomethyl ether, propylene glycol monoethyl ether, propylene glycol monoisopropyl ether, propylene glycol monobutyl ether, propylene glycol monohexyl ether, propylene glycol monoethylhexyl ether, propylene glycol monophenyl ether, propylene glycol monobenzyl ether, dipropylene glycol monomethyl ether, dipropylene glycol monoethyl ether, dipropylene glycol monoisopropyl ether, dipropylene glycol monobutyl ether, dipropylene glycol monohexyl ether, dipropylene glycol monoethylhexyl ether, dipropylene glycol monophenyl ether and dipropylene glycol monobenzyl ether; and glycol ester solvents (the foregoing glycol ether solvents to which an acetic acid group is added) such as ethylene glycol monoethyl ether acetate, ethylene glycol monoisopropyl ether acetate, ethylene glycol monobutyl ether acetate, ethylene glycol monohexyl ether acetate, ethylene glycol monoethylhexyl ether acetate, ethylene glycol monophenyl ether acetate and ethylene glycol monobenzyl ether acetate are preferable.

### (Other additives)

The silicone resin composition of the present embodiment may comprise a silane coupling agent or other additives.

### <<Silane coupling agent>>

The silane coupling agent provides an effect of improving adhesion between the cured product of a silicone resin composition, and the semiconductor light-emitting element or the substrate. The silane coupling agent is preferably a silane coupling agent having at least one selected from the group consisting of vinyl group, epoxy group, styryl group, methacryl group, acryl group, amino group, ureido group, mercapto group, sulfide group and isocyanate group, more preferably a silane coupling agent having an epoxy group or a mercapto group.

Specific examples of the silane coupling agent include 2-(3,4-epoxycyclohexyl)ethyltrimethoxysilane, 3-glycidoxypropylmethyldimethoxysilane, 3-glycidoxypropyltrimethoxysilane, 3-glycidoxypropylmethyldiethoxysilane, 3-glycidoxypropyltriethoxysilane, 3-mercaptopropylmethyldimethoxysilane, 3-mercaptopropyltrimethoxysilane and the like.

When the silicone resin composition of the present embodiment comprises a silane coupling agent, a silicon atom contained in the silane coupling agent is also detected as a signal of ²⁹Si-NMR. Therefore, in the present description, a signal of the silane coupling agent is also included at the time of calculating a signal area (a signal area attributed to A1 silicon atom, a signal area attributed to A2 silicon atom, and a signal area attributed to A3 silicon atom) of the silicone resin composition.

The content of the silane coupling agent in the silicone resin composition of the present embodiment is preferably 0.0001 parts by mass or more and 1.0 part by mass or less, more preferably 0.001 parts by mass or more and 0.1 parts by mass or less, to 100 parts by mass of the content of the first silicone resin, or to 100 parts by mass of the total content of the first silicone resin and the second silicone resin. When the content of the silane coupling agent is higher than the above range, transparency of the cured product of a silicone resin composition may in some cases decrease because the silane coupling agent itself absorbs light.

The silane coupling agent may be used while it is mixed with the silicone resin composition of the present embodiment. Also, it is possible to preliminarily adhere a silane coupling agent on the surface of the semiconductor light-emitting element or the substrate by coating or a dipping treatment, and then form the silicone resin composition of the present embodiment by potting or the like and cure the silicone resin composition.

### <<Other additives>>

Examples of other additives include silicone resins other than the first silicone resin and the second silicone resin, silicone oligomers, and silicone compounds. Specific examples of other additives include general modifier silicone compounds that are industrially, commercially available. By comprising such a modifier silicone compound in the silicone resin composition of the present embodiment, it is possible to impart the flexibility to the cured product of a silicone resin composition. Examples of the modifier silicone compound include polymers, oligomers and the like that have a dialkylsiloxane structure including R₂SiO_{2/2} (wherein, R represents an alkyl group) as a backbone.

When the silicone resin composition of the present embodiment comprises a silicone compound, a silicon atom contained in the silicone compound is also detected as a signal of ²⁹Si-NMR. Therefore, in the present description, a signal of the silicone compound is also included at the time of calculating a signal area (a signal area attributed to A1 silicon atom, a signal area attributed to A2 silicon atom, and a signal area attributed to A3 silicon atom) of the silicone resin composition.

The content of the silicone compound in the silicone resin composition of the present embodiment is preferably 0.1 parts by mass or more and 20 parts by mass or less, more preferably 0.5 parts by mass or more and 10 parts by mass or less, to 100 parts by mass of the content of the first silicone resin, or to 100 parts by mass of the total content of the first silicone resin and the second silicone resin. When the content of the silicone compound is higher than the above range, transparency of cured product of a silicone resin composition may in some cases be deteriorated.

Other examples of the additives include a defoaming agent for suppressing air bubbles that are generated at the time of mixing the silicone resin composition.

The silicone resin composition of the present embodiment can be obtained by mixing the silicone resins, organic solvents and the like by an ordinarily employed known method.

### [Cured product of silicone resin composition]

Hereinafter, a cured product of a silicone resin composition which is one embodiment of the present invention is described.

By curing the silicone resin composition of the present embodiment, for example, at 120°C or higher and 200°C or lower, it is possible to obtain a cured product of a silicone resin composition (hereinafter, also referred to as "cured product of the present embodiment"). The curing time is preferably 1 hour or more and 100 hours or less, more preferably 5 hours or more and 70 hours or less, further preferably 5 hours or more and 50 hours or less.

The cured product of the present embodiment can be obtained by curing the silicone resin composition of the present embodiment, for example, at 160°C for 10 hours. The cured product obtained in this manner has, for example, a Shore hardness of about D70 as measured in conformity with JIS K6253-3:2012.

Since the cured product of the present embodiment is excellent also in UV stability, it is useful as an encapsulating material for a semiconductor light-emitting element (LED), photo diode, CCD, CMOS and so on, particularly, as an encapsulating material for a UV-LED that emits UV light.

As described above, the silicone resin composition of the present embodiment is useful for production of a cured product of a silicone resin composition having high UV stability.

### [Encapsulating material for semiconductor light-emitting element]

Hereinafter, an encapsulating material for a semiconductor light-emitting element which is one embodiment of the present invention is described.

Since the encapsulating material for a semiconductor light-emitting element of the present embodiment comprises the cured product of the silicone resin composition of the present embodiment, it becomes an encapsulating material for a semiconductor light-emitting element having high UV stability.

### EXAMPLES

Hereafter, the present invention will be specifically described by showing Examples. However, the present invention is not limited to these Examples.

In the present Example, as a means for measuring the kind of silicon atoms and the existence ratio of substituents in the silicone resin composition, a solution ¹H-NMR method, a solution ²⁹Si-NMR method or a solid ²⁹Si-NMR method was used. For measurement of the molecular weight of the silicone resin, the GPC method was used. The conditions in each of the measurement methods are as follows.

### <Solution ¹H-NMR measurement condition>

Device name: ECA-500 manufactured by JEOL RESONANCE Inc.
Observation nucleus: ¹H
Observation frequency: 500.16 MHz
Measurement temperature: room temperature
Measurement solvent: DMSO-d₆
Pulse width: 6.60 µsec (45°)
Pulse repeating time: 7.0 sec
Accumulation times: 16 times
Sample concentration (sample/measurement solvent) : 300 mg/0.6 mL

### <Solution ²⁹Si-NMR measurement condition>

Device name: 400-MR manufactured by Agilent Technologies Japan, Ltd.
Observation nucleus: ²⁹Si
Observation frequency: 79.42 MHz
Measurement temperature: room temperature
Measurement solvent: CDCl₃
Pulse width: 8.40 µsec (45°)
Pulse repeating time: 15.0 sec
Accumulation times: 4000 times
Sample concentration (sample/measurement solvent) : 300 mg/0.6 mL

### <Solution ²⁹Si-NMR measurement method>

Device name: AVANCE300 400-MR manufactured by Bruker Corporation
Observation nucleus: ²⁹Si
Observation frequency: 59.6 MHz
Measurement temperature: room temperature
Measurement method: DDMAS method
Reference material: hexamethylcyclotrisiloxane (set at -9.66 ppm, corresponding to setting TSM at 0 ppm)
MAS condition: 3.5 kHz
Pulse width: π/6 (1.4 ms)
Wait time: 20.0 sec
Accumulation times: 4096 times
Sample amount: 180 mg

### <GPC measurement condition>

Apparatus: HLC-8220 manufactured by TOSOH CORPORATION
Column: TSKgel Multipore HXL-M×3 + Guard column-MP(XL)
Flow rate: 1.0 mL/min
Detection conditions: RI (polarity +)
Concentration: 100 mg + 5 mL (THF)
Injection amount: 100 µL
Column temperature: 40°C
Eluent: THF

In the present Example, a molar ratio of methyl groups, methoxy groups and hydroxyl groups that bond to silicon atoms existing in the silicone resin composition was measured by the solution ¹H-NMR or the solid ¹³C-NMR measurement. The conditions in each of the measurement methods are as follows.

In the present Example, when the object to be measured (silicone resin composition) contains a silicone resin that is insoluble in a measurement solvent, a molar ratio of methyl groups, methoxy groups and hydroxyl groups existing in the object to be measured (silicone resin composition) is measured in the following manner.

First, the silicone resin composition is subjected to a centrifugal separation treatment or a filtration treatment to separate the silicone resin composition into a silicone resin that is soluble in the measurement solvent and a silicone resin that is insoluble in the measurement solvent. Then, a molar ratio of methyl groups, methoxy groups and hydroxyl groups bonding to silicon atoms is measured, by conducting solution NMR measurement for the silicone resin that is soluble in the measurement solvent, and conducting solid NMR measurement for the silicone resin that is insoluble in the measurement solvent. Thereafter, by combining the measurements that are respectively determined, a molar ratio of methyl groups, methoxy groups and hydroxyl groups existing in the silicone resin composition can be determined.

Also, in place of separating silicone resins contained in the silicone resin composition, it is possible to measure a molar ratio of methyl groups, methoxy groups and hydroxyl groups bonding to silicon atoms for simple silicone resins which are the materials for the silicone resin composition, and determine the molar ratio of methyl groups, methoxy groups and hydroxyl groups existing in the silicone resin composition based on the blending ratio of the silicone resins contained in the silicone resin composition.

At this time, in the obtained NMR spectrum, a peak derived from an alkoxy group such as a methoxy group is detected in a chemical shift of 3.0 ppm to 4.0 ppm. However, a peak derived from a structure of a solvent component, a peak of a silanol group or the like is also detected as a similar chemical shift, and a plurality of peaks can be overlapped. In such a case, a treatment of determining a spectrum difference between the obtained NMR spectrum and the NMR spectrum of the solvent alone, a treatment of separating the peaks of alkoxy group and silanol group by varying the measurement environment temperature or the like can be carried out. By conducting such a treatment, a molar ratio of methoxy group alone can be determined.

### <Solution ¹H-NMR measurement condition>

Device name: 400-MR manufactured by Agilent Technologies Japan, Ltd.
Observation nucleus: ¹H
Observation frequency: 399.78 MHz
Measurement temperature: described in Examples and Comparative examples
Measurement solvent: described in Examples and Comparative examples
Pulse width: 6.00 µsec (45°)
Pulse repeating time: 30.0 sec
Accumulation times: 16 times
Sample concentration (sample/measurement solvent) : 100 mg/0.8 mL

### <Solid ¹³C-NMR measurement condition>

Device name: AVANCE300 400-MR manufactured by Bruker Corporation
Observation nucleus: ¹³C
Observation frequency: 75.4 MHz
Measurement temperature: room temperature
Measurement method: DDMAS method
Reference material: adamantane (set at 29.47 ppm, corresponding to setting TMS at 0 ppm)
MAS condition: 10 kHz
Pulse width: π/6 (1.5 ms)
Wait time: 10.0 sec
Accumulation times: 8192 times (measurement of reference) 16384 times (= 2¹⁴ times) (measurement of resin C)
Sample amount: 85 mg

In the present Example, the conditions of measurement of transmittance of silicone resin cured product, and a UV irradiation test are as follows.

### <Transmittance measurement>

Device name: UV-3600 manufactured by Shimadzu Corporation
Attachment: integrating sphere ISR-3100
Measurement wavelength: 220 to 800 nm
Background measurement: ambient atmosphere
Measurement speed: middle speed

### <UV irradiation test>

Device name: SP9-250DV manufactured by USHIO INC.
UV irradiation wavelength: 254 nm to 420 nm
UV irradiation intensity: 150 mW/cm²
Resin heating temperature: 50°C (by hot plate)
UV irradiation time: 300 hours

### (Example 1)

A silicone resin 1 having an organopolysiloxane structure represented by the above formula (1) (Mw = 3500, in the above formula (1), R¹ = methyl group, R² = methoxy group or hydroxyl group) was used as the first silicone resin. The existence ratio of each of the structural units of the silicone resin 1 is shown in Table 1.

**[Table 1]**

| | A2 silicon atom | | A3 silicon atom |
|---|---|---|---|
| Structural unit | 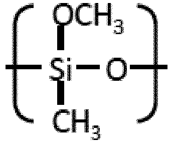 | 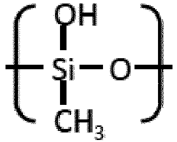 | 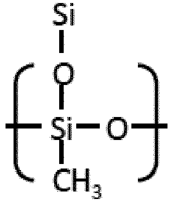 |
| Existence ratio | 0.08 | 0.15 | 0.77 |

A rate of reduction of mass was 10.3%, as measured by raising the temperature of the silicone resin 1 from the room temperature to 200°C at a temperature ramp-up rate of 5°C/min. and then retaining the silicone rasin 1 for 5 hours in air at 200°C.

As the second silicone resin, MSP-S110 (available from NIKKO RICA CORPORATION) was used. A rate of reduction of mass was 3.5%, as measured by raising the temperature of MSP-S110 from the room temperature to 200°C at a temperature ramp-up rate of 5°C/min. and then retaining MSP-S110 for 5 hours in air at 200°C. The existence ratio of each of the structural units of MSP-S110 is shown in Table 2.

**[Table 2]**

| | A2 silicon atom | | A3 silicon atom |
|---|---|---|---|
| Structural unit | 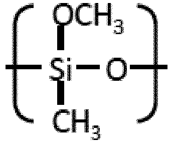 | 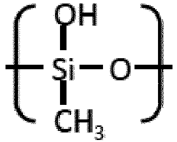 | 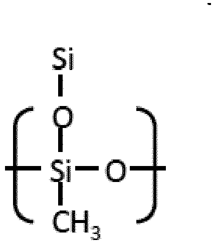 |
| Existence ratio | 0.004 | 0.358 | 0.638 |

A silicone resin composition of Example 1 was obtained by mixing 35.04 g of the silicone resin 1, 23.36 g of MSP-S110 as the second silicone resin, and 21.60 g of 2-ethoxyethyl acetate.

In the silicone resin composition of Example 1, a ratio of the content of the A3 silicon atoms to the total content of the A1 silicon atoms, the A2 silicon atoms and the A3 silicon atoms was 72%.

In the silicone resin composition of Example 1, a molar ratio of hydroxyl groups (silanol groups) bonding to silicon atoms to 100 of methyl groups (alkyl groups) bonding to silicon atoms was 17.5. In the silicone resin composition of Example 1, a molar ratio of methoxy groups (alkoxy groups) bonding to silicon atoms to 100 of methyl groups (alkyl groups) bonding to silicon atoms was 3.4.

At this time, the measurement temperature in ¹H-NMR measurement was a room temperature, and the measurement solvent was DMSO-d₆.

A cured product having a thickness of 1 mm was obtained by curing the silicone resin composition of Example 1 in a curing condition of incubation on an aluminum cup at 160°C for 10 hours without addition of a catalyst for curing. The cured product did not have adhesiveness (tackiness) . Also, cracking was not observed in the obtained cured product.

As a result of measurement of the transmittance of the obtained cured product, the transmittance of UV light at a wavelength of 280 nm was 91%.

UV irradiation test of the obtained cured product was conducted. As a result of measurement of the transmittance of the cured product after the UV irradiation test, the transmittance of UV light at a wavelength of 280 nm was 89%, and there was little difference compared with the transmittance of UV light before the UV irradiation test.

### (Comparative Example 1)

Using 0.75 mole of ethyl trimethoxysilane and dilute nitric acid as an acid catalyst, a mixture having a molar ratio of trifunctional silicon alkoxide : water : nitric acid of 1 : 3 : 0.002 was prepared. The obtained mixture was stirred in a closed vessel at 20°C for 3 hours, and then stood still at 60°C for 24 hours to conduct hydrolysis condensation polymerization. Since the obtained reaction liquid separates into a lower layer abundantly containing the condensation polymerization reaction liquid, and an upper layer abundantly containing methanol which is a by-product, the reaction liquid in the lower layer side was taken out with a separating funnel.

The obtained reaction liquid in the lower layer side was dried in air at 60°C for 2 hours, and then dried in vacuo at 40°C for 2 hours, to obtain a silicone resin composition of Comparative Example 1. The silicone resin composition of Comparative Example 1 had a content of the A3 silicon atoms to the total content of the A1 silicon atoms, the A2 silicon atoms and the A3 silicon atoms of 58.7%.

In the silicone resin composition of Comparative Example 1, a molar ratio of hydroxyl groups (silanol groups) bonding to silicon atoms to 100 of methyl groups (alkyl groups) bonding to silicon atoms was 36.4. In the silicone resin composition of Comparative Example 1, a molar ratio of methoxy groups (alkoxy groups) bonding to silicon atoms to 100 of methyl groups (alkyl groups) bonding to silicon atoms was 6.7.

At this time, the measurement temperature in ¹H-NMR measurement was 60°C, and the measurement solvent was DMSO-d₆.

A cured product was obtained in the same manner as in Example 1 except that a curing condition of incubating the silicone resin composition of Comparative Example 1 at 160°C for 24 hours was employed. The cured product did not have adhesiveness (tackiness). Also, cracking was not observed in the obtained cured product.

As a result of measurement of the transmittance of the obtained cured product, the transmittance of UV light at a wavelength of 280 nm was 72%, which was insufficient for use as an encapsulating material for a UV-LED.

UV irradiation test of the obtained cured product was conducted. As a result of measurement of the transmittance of the cured product after the UV irradiation test, the transmittance of UV light at a wavelength of 280 nm was 44%, and the transmittance largely reduced compared with the transmittance of UV light before the UV irradiation test.

### (Comparative Example 2)

In a flask, 12.7 g of methyltrimethoxysilane, 11.2 g of dimethyldimethoxysilane, 3.3 g of methanol, 8.1 g of water, and 4.8 g of a solution of 5 mass% acetylacetone aluminum salt in methanol were added. The flask was tightly stoppered, and the flask was placed in a warm water bath at 50°C, and then the obtained mixture was stirred for 8 hours using a stirrer. By returning the obtained mixture to room temperature, the silicone resin composition of Comparative Example 2 was obtained.

In the silicone resin composition of Comparative Example 2, a molar ratio of hydroxyl groups (silanol groups) bonding to silicon atoms to 100 of methyl groups (alkyl groups) bonding to silicon atoms was 46.6. In the silicone resin composition of Comparative Example 2, a molar ratio of methoxy groups (alkoxy groups) bonding to silicon atoms to 100 of methyl groups (alkyl groups) bonding to silicon atoms was 5.4.

At this time, the measurement temperature in ¹H-NMR measurement was 60°C, and the measurement solvent was DMSO-d₆.

Into a Teflon (trademark) petri dish having a diameter of 5 cm, 7.3 g of the silicone resin composition of Comparative Example 2 was added, and incubated at 40°C for 4 hours. The temperature was raised up to 65°C in 3 hours, and then raised up to 150°C in 1 hour, followed by incubation at 150°C for 3 hours, thereby producing a cured product having a thickness of 0.9 mm. The cured product did not have adhesiveness (tackiness). Also, cracking was not observed in the obtained cured product.

As a result of measurement of the transmittance of the obtained cured product, the transmittance of UV light at a wavelength of 280 nm was 0%.

These results revealed that the silicone resin composition of the present invention is useful.

### INDUSTRIAL APPLICABILITY

According to the present invention, it is possible to provide a silicone resin composition useful for production of a cured product of a silicone resin composition which shows high UV stability. Also, according to the present invention, it is possible to provide a cured product of the silicone resin composition. Also, according to the present invention, it is possible to provide an encapsulating material for a semiconductor light-emitting element, comprising a cured product of the silicone resin composition.

## Claims

1. A silicone resin composition comprising at least one silicone resin, satisfying the following requirements (i) to (iii) :
(i) silicon atoms contained therein essentially consist of at least one kind of silicon atoms selected from the group consisting of A1 silicon atoms and A2 silicon atoms, and A3 silicon atoms, and a ratio of the content of the A3 silicon atoms to the total content of the A1 silicon atoms, the A2 silicon atoms and the A3 silicon atoms is 50 mol% or more and 99 mol% or less;
(ii) side chains bonding to the silicon atoms are alkyl groups having 1 to 3 carbons, alkoxy groups having 1 or 2 carbons or hydroxyl groups, a molar ratio of the alkoxy groups is less than 5 to 100 of the alkyl groups, and a molar ratio of the hydroxyl groups is 10 or more to 100 of the alkyl groups; and
(iii) a metallic catalyst is not substantially contained;
wherein
A1 silicon atom denotes a silicon atom in the structural unit represented by the following formula (A1) bonding to one oxygen atom which bonds to a silicon atom in other structural unit, one R¹ and two R²s, or a silicon atom in the structural unit represented by the following formula (A1') bonding to one bonding hand which bonds to an oxygen atom that bonds to a silicon atom in other structural unit, one R¹ and two R²s,
A2 silicon atom denotes a silicon atom in the structural unit represented by the following formula (A2) bonding to one oxygen atom which bonds to a silicon atom in other structural unit, one bonding hand which bonds to an oxygen atom that bonds to a silicon atom in other structural unit, one R¹ and one R²,
A3 silicon atom denotes a silicon atom in the structural unit represented by the following formula (A3) bonding to two oxygen atoms each of which bonds to a silicon atom in other structural unit, one bonding hand which bonds to an oxygen atom that bonds to a silicon atom in other structural unit, and one R¹, and
R¹ represents an alkyl group having 1 to 3 carbons, and R² represents an alkoxy group having 1 or 2 carbons or a hydroxyl group.

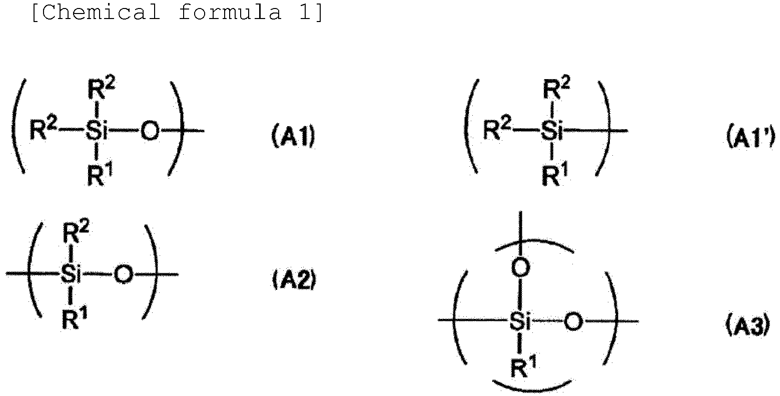

2. The silicone resin composition according to claim 1, comprising the following first silicone resin as the silicone resin;
A first silicone resin:
A silicone resin wherein silicon atoms contained therein essentially consist of at least one kind of silicon atoms selected from the group consisting of the A1 silicon atoms and the A2 silicon atoms, and the A3 silicon atoms, a ratio of the content of the A3 silicon atoms to the total content of the A1 silicon atoms, the A2 silicon atoms and the A3 silicon atoms is 60 mol% or more and 90 mol% or less, and the silicone resin has a weight-average molecular weight of 1500 or more and 8000 or less.

3. The silicone resin composition according to claim 1 or 2, comprising the following second silicone resin as the silicone resin;
A second silicone resin:
A silicone resin having a rate of reduction of mass of less than 5%, as measured by raising the temperature of the silicone resin from a room temperature to 200°C at a temperature ramp-up rate of 5°C/min. and then retaining the silicone resin for 5 hours in air at 200°C.

4. A cured product of the silicone resin composition according to any one of claims 1 to 3.

5. An encapsulating material for a semiconductor light-emitting element, comprising a cured product of the silicone resin composition according to any one of claims 1 to 3.
